# EUROPEAN PATENT APPLICATION

(11) **EP 1 006 580 A2**
(43) Date of publication of application: **07.06.2000**
(21) Application number: 99120841.4
(22) Date of filing: 25.10.1999
(51) Int. Cl.: H01L 27/115, H01L 21/8247, H01L 21/02

(54) **Semiconductor memory device having a hydrogen barrier layer, and method for manufacturing the same**

(30) Priority: 03.12.1998 JP 34389698
(71) Applicant: Matsushita Electronics Corporation, Takatsuki-shi, Osaka 569-1193 (JP)
(72) Inventor: Nagano, Yoshihisa, Suita-shi, Osaka, 565-0863 (JP); Tanaka, Keisuke, Otsu-shi, Shiga, 520-2145 (JP); Nasu, Toru, Kyoto-shi, Kyoto, 604-8474 (JP)
(74) Representative: Kügele, Bernhard

(57) **Abstract**

A semiconductor memory device which comprises a first protective insulation film 3 covering the whole surface of a semiconductor substrate having a transistor composed of a source region, a drain region and a gate integrated thereon, a capacitative element for data storage composed of a lower electrode 4, a capacitative film 5 of an insulating metal oxide and an upper electrode 6 formed on the first protective insulation film 3, a second protective insulation film 7 covering the whole surface of first protective insulation film 3 and the capacitative elements, a hydrogen barrier layer 10, 11 formed to cover the whole surfaces of contact holes 8, 9 formed through the second protective insulation film 7 penetrating respectively to the upper electrode 6 and the lower electrode 4 and the exposed surfaces of upper electrode 6 and lower electrode 4, a contact hole 12 formed through the first protective insulation film 3 and the second protective insulation film 7 penetrating to the transistor, and an interconnection layer 13 which electrically connects the capacitative element and the transistor. In the memory device, the catalytic reaction against hydrogen, which takes place at the surfaces of upper electrode and the lower electrode during resist removal with oxygen plasma, can be suppressed. Thus, a semiconductor memory device containing capacitative elements of high reliability is presented.

## Description

### FIELD OF THE INVENTION

The present invention relates to a semiconductor memory device using an insulating metal oxide for the capacitative film, and to a method of manufacturing the device.

### BACKGROUND OF THE INVENTION

In the era of digital technology, where volume of data to be processed and stored is steeply increasing along with the multiplying functions of electronic appliances, design rules of the semiconductor devices used in such appliances are required to have finer patterns. In order to increase the integration density of a dynamic RAM, quite a number of study programs are under way regarding the use of a dielectric material of high dielectric constant for the capacitative insulation film, in place of the conventional silicon oxide or silicon nitride. Furthermore, many research and development activities are focused to a ferroelectric film having spontaneous polarization characteristic, with an aim to implement a high-speed read/write non-volatile RAM operating at a low voltage. A most important task to be solved for realizing such a semiconductor memory device is to develop a process for integrating a capacitative element on a CMOS integrated circuit that does not invite a deterioration in the characteristics.

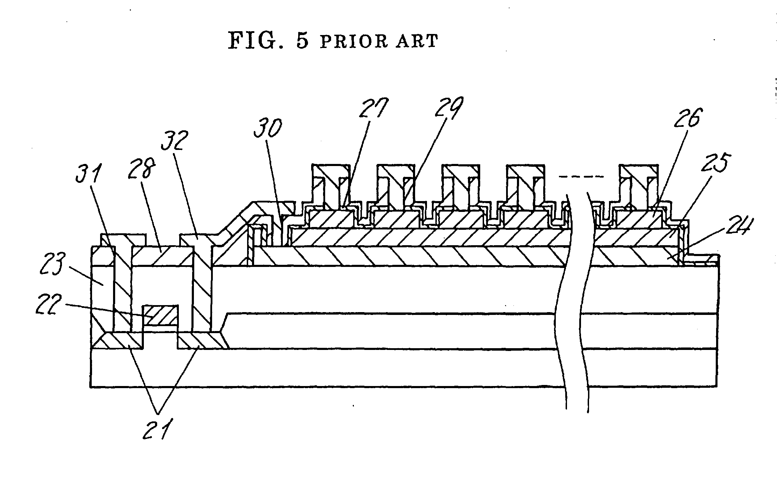

In the following, a conventional semiconductor memory device and a method of manufacturing it are described referring to FIG. 5.

As shown in FIG. 5, a first protective insulation layer 23 covers the whole surface of a semiconductor substrate having a transistor formed of a source region, drain region 21 and a gate electrode 22 integrated thereon. Formed on the first protective insulation film 23 is a capacitative element for data storage, composed of a lower electrode 24, a capacitative film 25 of insulating metal oxide and an upper electrode 26. Covering the capacitative elements is a hydrogen barrier layer 27. And a second protective insulation film 28 is formed to cover the entire surface of the first insulation film 23 and the hydrogen barrier layer 27.

A contact hole 29 penetrating to the upper electrode 26 and a contact hole 30 penetrating to the lower electrode 24 are formed by etching the second insulation film 28 and the hydrogen barrier layer 27. A contact hole 31 penetrating to the transistor is formed by etching the first insulation film 23 and the second insulation film 28. Finally, an interconnection layer 32 is formed in a certain specific region to connect the transistor and the capacitative element.

In the above described conventional semiconductor memory device, the hydrogen barrier layer 27 is formed covering the capacitative elements and the hydrogen barrier layer 27 uses a material that enables the layer to function as an interconnection layer as well as to act as a barrier against hydrogen. Therefore, in the process steps after formation of the interconnection layer, a deterioration of the characteristics of capacitative elements, which arises as a result of reductive reaction of the capacitative elements made of an insulating metal oxide, can be suppressed.

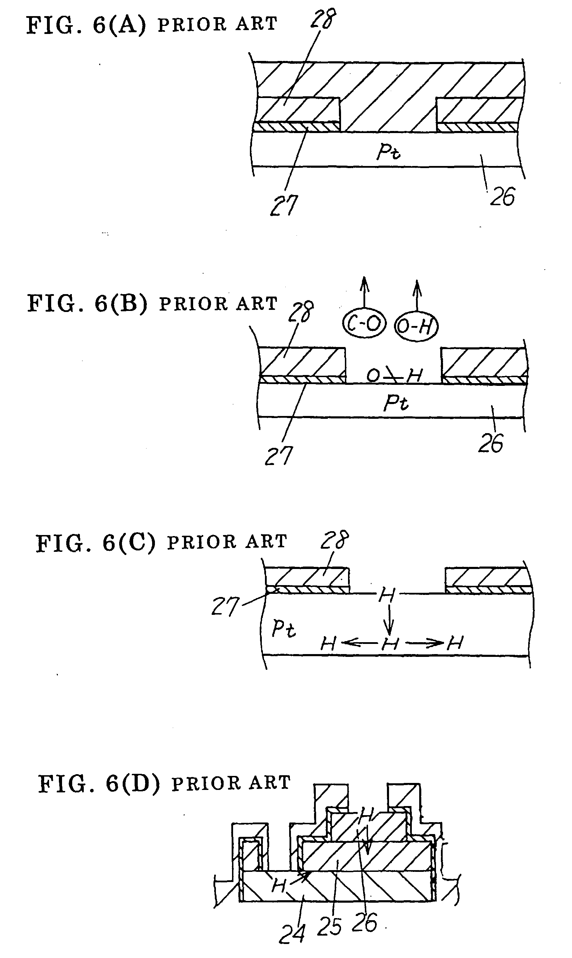

However, in the conventional process, a resist is provided, as shown in FIG. 6(A), on the second protective insulation film 28 when forming a contact hole in the second insulation film 28 disposed on a platinum electrode of upper electrode 26 or lower electrode 24 (not shown). Then, as shown in FIG. 6(B), the resist is removed in oxygen plasma. When, part of OH radical generated during the resist removal is decomposed through the catalytic reaction on the surface of platinum, and active hydrogen is produced. The active hydrogen diffuses into the platinum, as shown in FIG. 6(C), it further diffuses into the capacitative film 25 from the upper electrode 26 and the lower electrode 24, as shown in FIG. 6(D), to reduce the capacitative film made of an insulating metal oxide resulting in a deterioration of characteristics of the capacitative element.

The catalytic reaction against hydrogen at the surface of platinum is always observed at the following two process steps during manufacture of the semiconductor memory devices having capacitative elements.

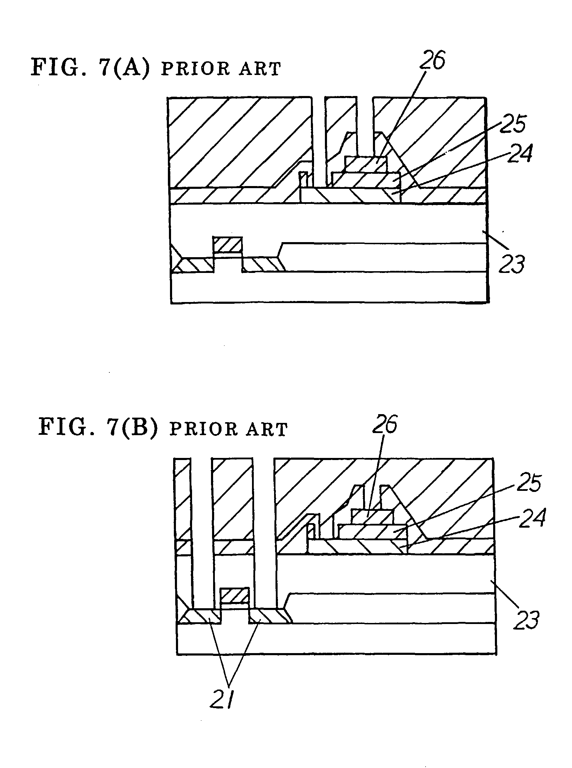

One of the two steps is the resist removal by oxygen plasma conducted after the contact holes are etched to the upper electrode 26 and the lower electrode 24 of capacitative element, FIG. 7(A). The other is the resist removal by oxygen plasma conducted after the contact holes are etched to the drain region and source region 21 of transistor, FIG. 7(B).

In the former case of FIG. 7(A), the once reduced insulating metal oxide can be oxidized again by applying a heat treatment in oxygen atmosphere after the resist is removed. In the latter case of FIG. 7(B), however, it is impossible to apply the heat treatment in oxygen atmosphere because the surface of contact hole penetrating to drain region and source region 21 is silicon, which can easily be oxidized.

As described in the above, a deterioration of characteristics of the capacitative element due to reductive reaction in the capacitative film, which is made of an insulating metal oxide, is not avoidable because of the catalytic reaction against hydrogen at the surface of platinum.

The present invention addresses the above problem, and aims to suppress the catalytic reaction against hydrogen at the platinum surface by providing a simple structuring. It can prevent the deterioration of characteristics of capacitative element caused by a reductive reaction in the capacitative film, which is made of an insulating metal oxide. Thus a semiconductor memory device of superior characteristics is presented, together with a method of manufacturing the same.

### SUMMARY OF THE INVENTION

A semiconductor memory device of the present invention comprises a semiconductor substrate having a transistor composed of a source region, a drain region and a gate integrated thereon, a first protective insulation film covering the whole surface of the semiconductor substrate, a capacitative element for data storage composed of a lower electrode, a capacitative film of an insulating metal oxide and an upper electrode formed on the first protective insulation film, a second protective insulation film covering the first protective insulation film and the capacitative element, a hydrogen barrier layer formed on the surface of contact holes provided in the second protective insulation film and penetrating to the upper electrode and the lower electrode in a way the surfaces of upper electrode and lower electrode are not exposed, and an interconnection layer provided in a contact hole formed through the first protective insulation film and the second protective insulation film penetrating to the transistor for electrically connecting the capacitative element and the transistor.

A method of manufacturing a semiconductor memory device in accordance with the present invention comprises the steps of forming a first protective insulation film to cover the whole surface of a semiconductor substrate having a transistor composed of a source region, a drain region and a gate integrated thereon, forming a capacitative element for data storage composed of a lower electrode, a capacitative film of an insulating metal oxide and an upper electrode on the first protective insulation film, forming a second protective insulation film covering the entire surface of the first protective insulation film and the capacitative element, providing a resist on the second protective insulation film and forming on the resist a mask pattern for forming contact holes to the upper electrode and the lower electrode, forming contact holes penetrating respectively to the upper electrode and the lower electrode by etching the second protective insulation film using the mask pattern, removing the resist with oxygen plasma and then applying a heat treatment, forming a hydrogen barrier layer to cover the entire surfaces of the contact hole penetrating to the upper electrode and the contact hole penetrating to the lower electrode and exposed surfaces of the upper electrode and the lower electrode, providing a resist on the second protective insulation film and the hydrogen barrier layer and then forming on the resist a mask pattern for forming a contact hole penetrating to the transistor, forming a contact hole penetrating to the transistor by etching the first protective insulation film and the second protective insulation film using the mask pattern, removing the resist with oxygen plasma, and forming an interconnection layer for electrically connecting the capacitative element and the transistor. In accordance with the above described process, even when a catalytic reaction against hydrogen takes place at the surfaces of the upper electrode and the lower electrode during the resist removing with oxygen plasma after the contact holes to the upper electrode and the lower electrode are formed, the capacitative film can be oxidized again by applying a heat treatment in oxygen atmosphere; in the resist removing with oxygen plasma after the contact hole to the transistor is formed, there will be no catalytic reaction against hydrogen at the surfaces of the upper electrode and the lower electrode because a hydrogen barrier layer has already been formed not to expose the surfaces of the upper electrode and the lower electrode. Thus, the capacitative film is not reduced, and a semiconductor memory device having reliable capacitative elements is offered.

### BRIEF DESCRIPTION OF THE DRAWINGS

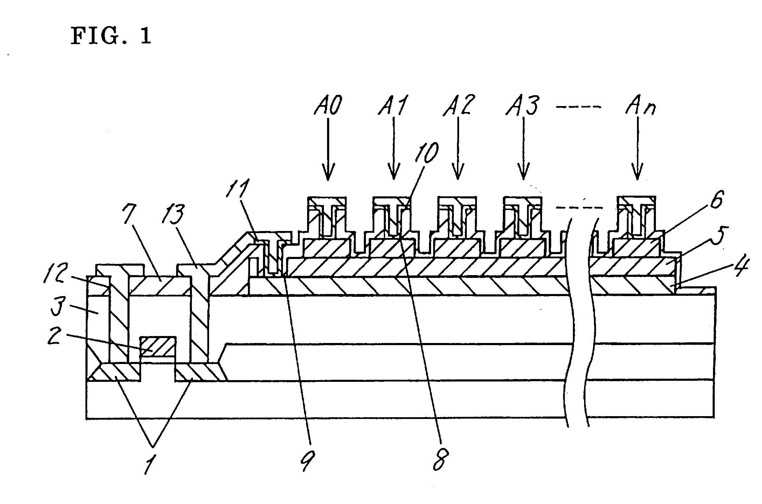

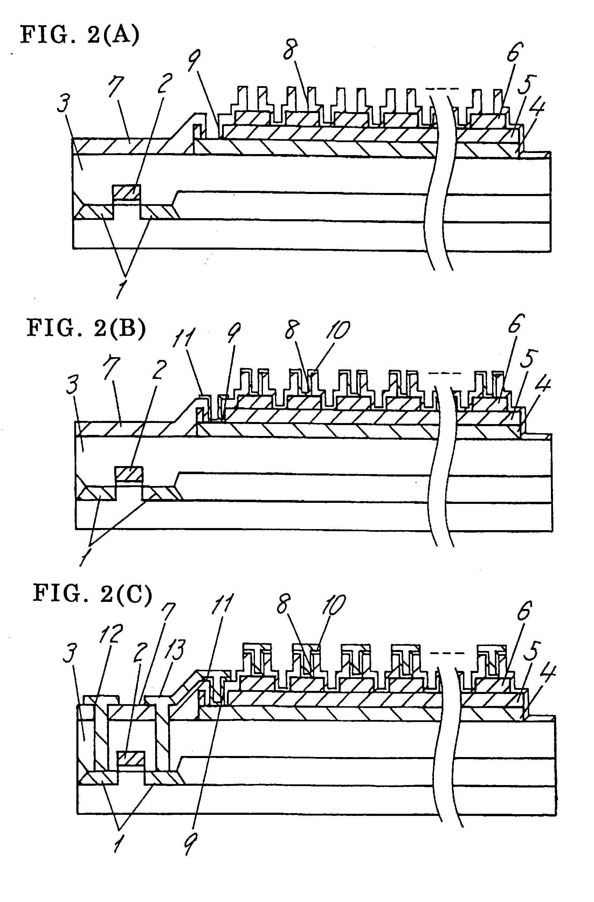

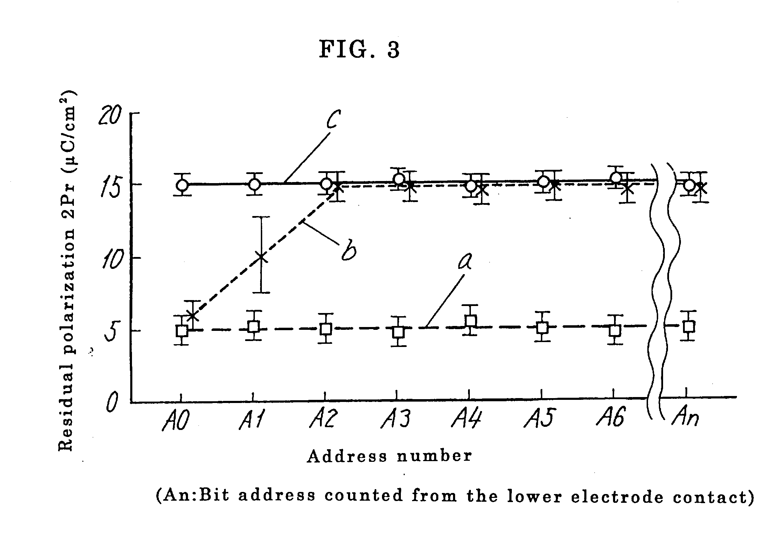

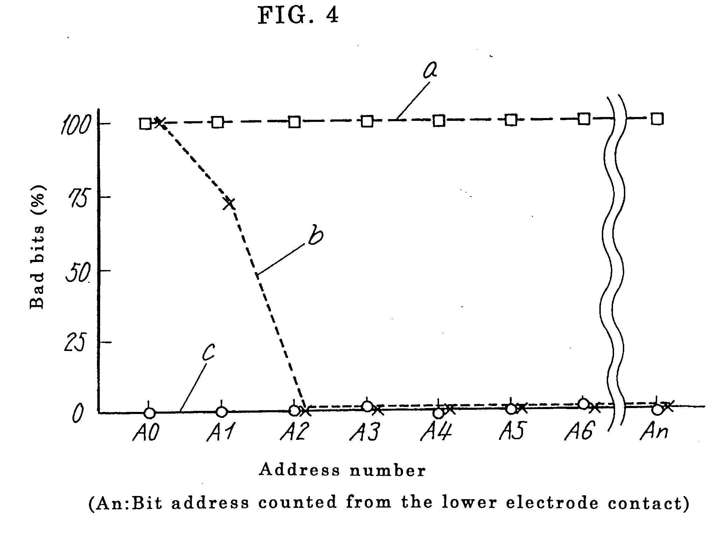

FIG. 1 is a cross sectional view, showing a key portion of a semiconductor memory device in accordance with an exemplary embodiment of the present invention. FIG. 2(A) - FIG. 2(C) are cross sectional views, showing manufacturing process steps of a semiconductor memory device in accordance with an exemplary embodiment of the present invention. FIG. 3 is a characteristics chart, showing the electrical characteristics of capacitative elements of a memory device in accordance with an exemplary embodiment of the present invention. FIG. 4 is a characteristics chart, showing the electrical characteristics of a semiconductor memory device in accordance with an exemplary embodiment of the present invention. FIG. 5 is a cross sectional view, showing a part of a conventional semiconductor memory device. FIG. 6(A) - FIG. 6(D) are cross sectional views of a conventional semiconductor memory device, used to describe the mechanism how failures occur in a conventional manufacturing method for a semiconductor memory device. FIG. 7(A) and FIG. 7(B) are cross sectional views, used to describe the process step of a conventional manufacturing method at which the failure occurs.

### DESCRIPTION OF PREFERRED EMBODIMENTS

Exemplary embodiments of the present invention are described in the following with reference to FIG. 1 and FIG. 2.

Referring to FIG. 2(A), a first protective insulation film 3 is formed covering the whole surface of a semiconductor substrate having a transistor composed of a source region, a drain region 1 and a gate 2 integrated thereon. On the first protective insulation film 3, a lower electrode 4 of platinum is provided by means of sputtering, a capacitative film 5 of SrBi₂(Ta₁₋ₓ Nbₓ)O₉ is provided by means of metalo-organic decomposition, or MOCVD, or sputtering, and an upper electrode 6 of platinum by means of sputtering. Then, the lower electrode 4, capacitative film 5 and upper electrode 6 are formed to a certain specific shape by means of dry-etching into capacitative elements for data storage.

A second protective insulation film 7 is provided covering the whole surface of the first protective insulation film 3 and the capacitative elements. And then, a resist is provided to cover the whole surface of the second protective insulation film 7. The second protective insulation film 7 is dry-etched using a mask pattern disposed on the resist, to form a contact hole 8 penetrating to the upper electrode 6 and a contact hole 9 penetrating to the lower electrode 4.

The resist is removed using oxygen plasma, and a heat treatment is applied in an oxygen atmosphere of 650°C.

Then, as shown in FIG. 2(B), a titanium nitride layer, which later become an oxygen barrier layer, is formed by sputtering to cover the whole surface of the substrate, and a mask pattern is formed by photo-lithography so that the surface of contact hole 8 as well as the surface of upper electrode 6 and the surface of contact hole 9 as well as the surface of lower electrode 4 are not exposed. It is, then, processed to a certain specific shape by dry-etching to form a hydrogen barrier layer 10 of titanium nitride on the surfaces of contact hole 8 as well as upper electrode 6, and a hydrogen barrier layer 11 of titanium nitride on the surfaces of contact hole 9 as well as lower electrode 4.

Then, as shown in FIG. 2(C), a resist is provided covering the whole surface of the second protective insulation film 7 and the hydrogen barrier layers 10, 11, and a mask pattern is formed by photo-lithography for the formation of a contact hole penetrating to the transistor. A contact hole 12 is formed penetrating to the transistor by selectively dry-etching the first protective insulation film 3 and the second protective insulation film 7. The resist is removed using oxygen plasma.

Finally, an interconnection layer 13 is formed for electrically connecting the capacitative element and the transistor, by stacking, in the order from the bottom, titanium, titanium nitride, aluminum and titanium nitride.

As described in the above, even if a catalytic reaction against hydrogen takes place at the surfaces of upper electrode 6 and lower electrode 4 during the resist removal with oxygen plasma after the contact holes 8, 9 to upper electrode and lower electrode are formed, the capacitative film 5 can be oxidized again by applying a heat treatment in an oxygen atmosphere after the resist removal.

During the resist removal with oxygen plasma after the contact hole 12 penetrating to the transistor is formed, no catalytic reaction against hydrogen takes place at the surfaces of upper electrode 6 and lower electrode 4 because the surfaces of contact holes 8, 9 are completely covered by the hydrogen barrier layers 10, 11 in a way the surfaces of both electrodes 6 and 4 are not exposed. Therefore, the capacitative film 5 is not reduced.

Now in the following, results of a study conducted to compare the characteristics of a conventional semiconductor memory device with those of a semiconductor memory device of the present invention are described.

FIG. 3 shows residual polarization (vertical axis) of capacitative elements at corresponding bit address (horizontal axis) illustrated in FIG. 1. The address numbers, A0, A1, A2 - - - An, are given in accordance with the sequence from the contact hole 9 penetrating to the lower electrode 4, A0 being the nearest to contact hole 9 (see FIG. 1).

As seen in FIG. 3, the conventional semiconductor memory device (represented with "a") has a substantially deteriorated residual polarization, 5µC/cm² , in the capacitative element at each of the addresses. This is because of a reduced capacitative film, which has been caused by a catalytic reaction against hydrogen occurred at the surfaces of upper electrode and lower electrode.

In a case where the hydrogen barrier layer 10 of titanium nitride is provided only in the contact hole 8 penetrating to the upper electrode 6 (represented with "b"), the deteriorated residual polarization is observed at the addresses A0 and A1, locating close to the contact hole 9 penetrating to lower electrode 4. The catalytic reaction against hydrogen occurred at the surface of lower electrode 4 in the contact hole 9 caused a diffusing of the hydrogen in the horizontal direction from contact hole 9, which was reaching as far as the capacitative elements at addresses A0 and A1, resulting in a reduced capacitative film. This explains the reason why the above phenomenon occurred.

In the case of the present invention, where the hydrogen barrier layers 10, 11 of titanium nitride is provided covering the surface of contact hole 8 penetrating to upper electrode 6 and the surface of contact hole 9 penetrating to lower electrode 4 (represented with "c"), no deterioration in residual polarity is observed at any address. This is because occurrence of the catalytic reaction against hydrogen at the surfaces of upper electrode 6 and lower electrode 4 has been completely blocked, and there is no reduction of the capacitative film.

Results of a comparative study on the characteristics of a semiconductor memory device of the present invention and a conventional device are shown in FIG. 4. Percentage of bad bits (vertical axis) at corresponding address (horizontal axis) of FIG. 1 is illustrated.

Conventional semiconductor memory device (represented with "a") had a remarkable deterioration of the residual polarity, to a rate 100% in each of the addresses. A semiconductor memory device having a hydrogen barrier layer 10 of titanium nitride in the contact hole 8 only (represented with "b") had bad bits in the addresses A0 and A1, which are locating close to the contact hole 9.

A semiconductor memory device of the present invention (represented with "c") attained a 0% rate at each of the addresses. This may be an evidence that the characteristics of capacitative elements give an immediate influence on the characteristics of a semiconductor memory device.

As described in the above exemplary embodiments, a semiconductor memory device of superior characteristics having highly reliable capacitative elements is offered in accordance with the present invention.

In the method of manufacturing a semiconductor memory device in accordance with the present invention, the heat treatment after resist removal has been conducted in a 650°C oxygen. However, the same effect is obtainable by applying the heat treatment within a temperature range from 600°C to 850°C, where oxidation of capacitative element can take place.

Although titanium nitride has been used for the hydrogen barrier layer in the above described embodiments, such other conductive material that makes no catalytic reaction against hydrogen as tantalum nitride, iridium oxide, ruthenium oxide, rhodium oxide, or a laminated layer of some of these materials combined may be used instead for producing the same effects.

Although a material SrBi₂ (Ta₁₋ₓ Nbₓ) O₉ has been used for the capacitative film in the above described embodiments, other ferroelectric material having perovskite structure with bismuth layers, lead zirconate titanate, strontium barium titanate or tantalum pentoxide may be used instead for producing the same effects.

Although platinum has been used for the upper electrode and the lower electrode in the above described embodiments, the use of either iridium, ruthenium or rhodium, or a substance containing a laminated film of these materials combined may also lead to the same effects.

As described in the above, the catalytic reaction against hydrogen at the surfaces of upper electrode and lower electrode, which takes place during resist removal with oxygen plasma, can be suppressed with a manufacturing method in accordance with the present invention. As a result, the deterioration of characteristics due to reductive reaction in the capacitative film is eliminated, and semiconductor memory devices of superior characteristics are presented through a simple method.

## Claims

1. A semiconductor memory device comprising:
a semiconductor substrate having a transistor composed of a source region, a drain region and a gate integrated thereon,
a first protective insulation film covering the whole surface of the semiconductor substrate,
a capacitative element for data storage composed of a lower electrode, a capacitative film of insulating metal oxide and an upper electrode formed on said first protective insulation film,
a second protective insulation film covering said first protective insulation film and said capacitative element,
a hydrogen barrier layer covering the whole surfaces of contact holes formed through said second protective insulation film penetrating respectively to said upper electrode and said lower electrode and the exposed surfaces of said upper electrode and said lower electrode, and
an interconnection layer provided in a contact hole formed through said first protective insulation film and said second protective insulation film penetrating to said transistor for electrically connecting said capacitative element and said transistor.

2. The semiconductor memory device of claim 1, wherein said hydrogen barrier layer is of a material that is inert to the catalytic reaction against hydrogen and conductive.

3. The semiconductor memory device of claim 1 or claim 2, wherein said hydrogen barrier layer is of either titanium nitride, tantalum nitride, iridium oxide, ruthenium oxide or rhodium oxide, or a laminated film of these.

4. The semiconductor memory device of claim 1, wherein the insulating metal oxide forming said capacitative film is of either a ferroelectric material having perovskite structure with bismuth layers, lead zirconate titanate, strontium barium titanate or tantalum pentoxide.

5. The semiconductor memory device of claim 1, wherein said upper electrode and said lower electrode are of either platinum, iridium, ruthenium or rhodium, or a laminated film of these.

6. A method of manufacturing a semiconductor memory device comprising the steps of;
forming a first protective insulation film to cover the whole surface of a semiconductor substrate having a transistor composed of a source region, a drain region and a gate integrated thereon,
forming a capacitative element for data storage composed of a lower electrode, a capacitative film of an insulating metal oxide and an upper electrode on said first protective insulation film,
forming a second protective insulation film to cover the entire surface of said first protective insulation film and said capacitative element,
providing a resist on said second protective insulation film and forming on said resist a mask pattern for forming contact holes penetrating respectively to said upper electrode and said lower electrode,
forming contact holes penetrating respectively to said upper electrode and said lower electrode by etching said second protective insulation film using said mask pattern,
removing said resist with oxygen plasma and then applying a heat treatment,
forming a hydrogen barrier layer to cover the whole surfaces of said contact hole penetrating to the upper electrode and said contact hole penetrating to the lower electrode and exposed surfaces of said upper electrode and said lower electrode,
providing a resist on said second protective insulation film and said hydrogen barrier layer and forming on said resist a mask pattern for forming a contact hole penetrating to said transistor,
forming a contact hole penetrating to said transistor by etching said first protective insulation film and said second protective insulation film using said mask pattern,
removing said resist with oxygen plasma, and
forming an interconnection layer for electrically connecting said capacitative element and said transistor.

7. The method of manufacturing a semiconductor memory device recited in claim 6, wherein said heat treatment is conducted in an atmosphere containing oxygen within a temperature range from 600°C to 850°C.
